# EUROPEAN PATENT SPECIFICATION

(11) **EP 4 657 101 B1**
(45) Date of publication and mention of the grant of the patent: **02.09.2026**
(21) Application number: 25178508.5
(22) Date of filing: 23.05.2025
(51) Int. Cl.: G01R 31/42, G01R 31/52, G01R 27/02, G01R 31/36

(54) **ENERGY STORAGE SYSTEM AND INSULATION IMPEDANCE DETECTION METHOD FOR ENERGY STORAGE SYSTEM**
ENERGIESPEICHERSYSTEM UND ISOLATIONSIMPEDANZDETEKTIONSVERFAHREN FÜR ENERGIESPEICHERSYSTEM
SYSTÈME DE STOCKAGE D'ÉNERGIE ET PROCÉDÉ DE DÉTECTION D'IMPÉDANCE D'ISOLATION POUR SYSTÈME DE STOCKAGE D'ÉNERGIE

(30) Priority: 27.05.2024 CN 202410662039
(43) Date of publication of application: 03.12.2025
(73) Proprietor: Huawei Digital Power Technologies Co., Ltd., Shenzhen, Guangdong 518043 (CN)
(72) Inventor: YU, Shijiang, Shenzhen, 518043 (CN); LI, Lin, Shenzhen, 518043 (CN); CAO, Zhen, Shenzhen, 518043 (CN)
(74) Representative: Isarpatent

(56) References cited:
- CN-A- 116 436 069
- US-A1- 2021 408 796

## Description

### TECHNICAL FIELD

This application relates to the field of power electronics, and in particular, to an energy storage system and an insulation impedance detection method for an energy storage system.

### BACKGROUND

In a new energy power supply system, such as an energy storage system, a photovoltaic energy storage system, or a photovoltaic system, a ground impedance of the power supply system may be abnormal due to a cause such as battery spill, improper construction, or friction between a cable and a support that occurs on the power supply system. As a result, a short-circuit-to-ground fault occurs on a cable of an energy storage unit, a cable of a photovoltaic string, or the like in the system. Therefore, it is very important to monitor a short-circuit fault of the ground impedance of the power supply system to ensure safety of the power supply system. In a conventional power generation and power supply system, a dedicated detection device is usually installed to specially detect a ground impedance of the system. For example, a ground impedance of each direct current side line in the power supply system may be detected by using a ground insulation detection circuit, or a ground insulation detection apparatus may be installed to detect the ground impedance of the entire power supply system. However, the ground insulation detection circuit can perform self-check only before an inverter or a converter in the power supply system is powered on. When the power supply system normally runs, ground impedance detection is interfered by a current in the power supply system. The ground insulation detection apparatus may perform real-time detection when the power supply system normally runs. However, ground impedance detection precision of the ground insulation detection apparatus is poor. When there are a large quantity of inverters or converters, the ground insulation detection apparatus cannot locate a specific short-circuit-to-ground fault. In addition, a protection threshold for the ground insulation detection apparatus to trigger short-circuit-to-ground fault determining is a fixed value, and adaptability to power supply systems of different scales is poor. CN116436069A relates to insulation resistance detection for a multi-machine parallel system.

### SUMMARY

Embodiments of this application provide an energy storage system and an insulation impedance detection method for an energy storage system, so that real-time insulation impedance detection may be performed when the energy storage system normally runs, a specific short-circuit-to-ground fault can be located, and precision of short-circuit-to-ground fault detection is high, thereby greatly facilitating troubleshooting and rectification of the short-circuit-to-ground fault in the energy storage system.

According to a first aspect, this application provides an energy storage system. The energy storage system includes a plurality of energy storage converters, a plurality of energy storage units, one first insulation impedance detection apparatus, a plurality of second insulation impedance detection apparatuses, and one controller. The energy storage converters include direct current ends and alternating current ends, the energy storage units are connected to the direct current ends of the energy storage converters, the energy storage units are further connected to the second insulation impedance detection apparatuses in a one-to-one correspondence, the alternating current ends of the plurality of energy storage converters are connected in parallel and then are configured to connect to a power grid, and a parallel connection point of the alternating current ends of the plurality of energy storage converters is connected to the first insulation impedance detection apparatus. The first insulation impedance detection apparatus is configured to detect a first insulation impedance, where the first insulation impedance includes an insulation impedance between the ground and a combination of the plurality of energy storage converters and the plurality of energy storage units. One second insulation impedance detection apparatus is configured to detect a second insulation impedance, where the second insulation impedance includes an insulation impedance between an energy storage unit connected to the one second insulation impedance apparatus and the ground. The controller is configured to: when the first insulation impedance is abnormal, control the plurality of second insulation impedance detection apparatuses to detect a plurality of corresponding second insulation impedances; and if there is an abnormal second insulation impedance, the controller sends an alarm signal.

In this application, the energy storage system uses the controller to combine detection data from the first insulation impedance detection apparatus and the second insulation impedance detection apparatuses. When the first insulation impedance between the ground and a combination of the plurality of energy storage converters and the plurality of energy storage units that is detected by the first insulation impedance detection apparatus is abnormal, the second insulation impedance detection apparatuses are controlled to detect the corresponding second insulation impedances, so that real-time detection may be performed when the energy storage system normally runs, an energy storage unit on which a short-circuit-to-ground fault occurs can be specifically located, and precision of short-circuit-to-ground fault detection is high, thereby greatly facilitating troubleshooting and rectification of the short-circuit-to-ground fault in the energy storage system.

In a possible implementation, that the first insulation impedance is abnormal includes that the first insulation impedance is less than a first impedance alarm threshold, and if there is no abnormal second insulation impedance, the controller is further configured to reduce the first impedance alarm threshold. Herein, the first impedance alarm threshold for the first insulation impedance detection apparatus to trigger short-circuit-to-ground fault determining is adjusted, so that when a short-circuit-to-ground fault is falsely reported, the first impedance alarm threshold is further corrected to adapt to a current energy storage system. This improves precision of short-circuit-to-ground fault detection, and is highly adaptable to energy storage systems of different scales.

In a possible implementation, that the first insulation impedance is abnormal includes that a difference between first insulation impedances detected by the first insulation impedance detection apparatus at two moments is greater than a specified threshold. The controller obtains, at a plurality of moments, a plurality of first insulation impedances detected by the first insulation impedance detection apparatus, and determines, based on a difference between first insulation impedances detected at two moments, whether a short-circuit-to-ground fault occurs in the current energy storage system. This may improve precision of short-circuit-to-ground fault detection, and is highly adaptable to energy storage systems of different scales.

In a possible implementation, that the first insulation impedance is abnormal includes that in first insulation impedances detected by the first insulation impedance detection apparatus at two moments, a ratio of a first insulation impedance detected at an earlier moment to a first insulation impedance detected at a later moment is greater than a specified threshold. The controller obtains, at a plurality of moments, a plurality of first insulation impedances detected by the first insulation impedance detection apparatus, and determines, based on a ratio between first insulation impedances detected at two moments, whether a short-circuit-to-ground fault occurs in the current energy storage system. This may improve precision of short-circuit-to-ground fault detection, and is highly adaptable to energy storage systems of different scales.

In a possible implementation, that the first insulation impedance is abnormal includes that in first insulation impedances detected by the first insulation impedance detection apparatus at two moments, a ratio of a first insulation impedance detected at a later moment to a first insulation impedance detected at an earlier moment is less than a specified threshold. The controller obtains, at a plurality of moments, a plurality of first insulation impedances detected by the first insulation impedance detection apparatus, and determines, based on a ratio between first insulation impedances detected at two moments, whether a short-circuit-to-ground fault occurs in the current energy storage system. This may improve precision of short-circuit-to-ground fault detection, and is highly adaptable to energy storage systems of different scales.

In a possible implementation, the controller is configured to: when the first insulation impedance is abnormal, control, one by one, connections between the plurality of energy storage converters and the power grid to be disconnected, and control a second insulation impedance detection apparatus corresponding to the energy storage converter disconnected from the power grid to detect the second insulation impedance. When the first insulation impedance is abnormal, the controller controls, one by one, the connections between the plurality of energy storage converters and the power grid to be disconnected, and controls a second insulation impedance detection apparatus corresponding to an energy storage converter that is disconnected from the power grid, to perform impedance detection, so that the second insulation impedance detection apparatus is not affected by a current from the power grid when performing impedance detection, and normal working of the energy storage system is not affected each time a single second insulation impedance detection apparatus performs impedance detection, thereby further improving precision of short-circuit-to-ground fault detection.

In a possible implementation, the controller is configured to: when the first insulation impedance is abnormal, control the plurality of second insulation impedance detection apparatuses to detect a plurality of corresponding second insulation impedances; and if there is an abnormal second insulation impedance, the controller is further configured to disconnect an electrical connection between a corresponding energy storage unit and a corresponding energy storage converter, where the corresponding energy storage unit is connected to a second insulation impedance detection apparatus that detects the abnormality, and a direct current end of the corresponding energy storage converter is connected to the second insulation impedance detection apparatus that detects the abnormality. The electrical connection between the corresponding energy storage unit and the corresponding energy storage converter is disconnected, to prevent the energy storage unit on which a short-circuit-to-ground fault occurs from affecting normal running of the energy storage system, thereby improving working reliability of the energy storage system.

In a possible implementation, the energy storage units are connected to the direct current ends of the energy storage converters in a one-to-one correspondence, and the second insulation impedances further include insulation impedances of connection cables between the energy storage units and the correspondingly connected energy storage converters. Herein, all the plurality of energy storage units may alternatively be connected to one output bus, and are connected to the direct current ends of the plurality of energy storage converters by using the output bus.

In a possible implementation, that the second insulation impedance is abnormal includes that the second insulation impedance is less than a second impedance alarm threshold. Herein, with reference to detection data of the first insulation impedance and the second insulation impedances, when the detected first insulation impedance between the ground and a combination of the plurality of energy storage converters and the plurality of energy storage units is abnormal, the second insulation impedances corresponding to the energy storage units are obtained one by one, and a specific short-circuit-to-ground fault is located based on whether a second insulation impedance is less than the second impedance alarm threshold.

According to a second aspect, this application provides an insulation impedance detection method for an energy storage system. The method includes: detecting a first insulation impedance between the ground and a combination of a plurality of energy storage converters and a plurality of energy storage units, where the energy storage converters include direct current ends and alternating current ends, the energy storage units are connected to the direct current ends of the energy storage converters, and the alternating current ends of the plurality of energy storage converters are connected in parallel and then are configured to connect to a power grid; and when the first insulation impedance is abnormal, obtaining a plurality of second insulation impedances corresponding to the plurality of energy storage units, and if there is an abnormal second insulation impedance, sending an alarm signal.

In this application, with reference to detection data of the first insulation impedance and the second insulation impedances, when the detected first insulation impedance between the ground and a combination of the plurality of energy storage converters and the plurality of energy storage units is abnormal, the second insulation impedances corresponding to the energy storage units are obtained one by one, so that real-time detection may be performed when the energy storage system normally runs, a specific short-circuit-to-ground fault can be located, and precision of short-circuit-to-ground fault detection is high, thereby greatly facilitating troubleshooting and rectification of the short-circuit-to-ground fault in the energy storage system.

In a possible implementation, the method includes: when the first insulation impedance is less than a first impedance alarm threshold, the first insulation impedance is abnormal.

In a possible implementation, after the obtaining a plurality of second insulation impedances corresponding to the plurality of energy storage units, the method includes: if there is no abnormal second insulation impedance, reducing the first impedance alarm threshold. The first impedance alarm threshold for triggering short-circuit-to-ground fault determining is adjusted, so that when a short-circuit-to-ground fault is falsely reported, the first impedance alarm threshold is further corrected to adapt to a current energy storage system. This improves precision of short-circuit-to-ground fault detection, and is highly adaptable to energy storage systems of different scales.

In a possible implementation, the method includes: when a difference between first insulation impedances detected at two moments is greater than a specified threshold, the first insulation impedance is abnormal. A plurality of first insulation impedances are obtained at a plurality of moments, and it is determined, based on a difference between first insulation impedances detected at two moments, whether a short-circuit-to-ground fault occurs in the current energy storage system. This may improve precision of short-circuit-to-ground fault detection, and is highly adaptable to energy storage systems of different scales.

In a possible implementation, the method includes: in first insulation impedances detected at two moments, a ratio of a first insulation impedance detected at an earlier moment to a first insulation impedance detected at a later moment is greater than a specified threshold, or a ratio of a first insulation impedance detected at a later moment to a first insulation impedance detected at an earlier moment is less than a specified threshold. A plurality of first insulation impedances are obtained at a plurality of moments, and it is determined, based on a ratio between first insulation impedances detected at two moments, whether a short-circuit-to-ground fault occurs in the current energy storage system. This may improve precision of short-circuit-to-ground fault detection, and is highly adaptable to energy storage systems of different scales.

In a possible implementation, when a second insulation impedance is less than a second impedance alarm threshold, the second insulation impedance is abnormal. Herein, with reference to detection data of the first insulation impedance and the second insulation impedances, when the detected first insulation impedance between the ground and a combination of the plurality of energy storage converters and the plurality of energy storage units is abnormal, the second insulation impedances corresponding to the energy storage units are obtained one by one, and a specific short-circuit-to-ground fault is located based on whether a second insulation impedance is less than the second impedance alarm threshold.

### BRIEF DESCRIPTION OF DRAWINGS

FIG. 1 is a diagram of an application scenario of an energy storage system according to this application;
FIG. 2 is a diagram of a structure of an energy storage system according to this application;
FIG. 3 is another diagram of a structure of an energy storage system according to this application;
FIG. 4 is a diagram of an application scenario of a photovoltaic energy storage system according to this application;
FIG. 5 is a diagram of an application scenario of a photovoltaic system according to this application; and
FIG. 6 is a schematic flowchart of an insulation impedance detection method for an energy storage system according to this application.

### DESCRIPTION OF EMBODIMENTS

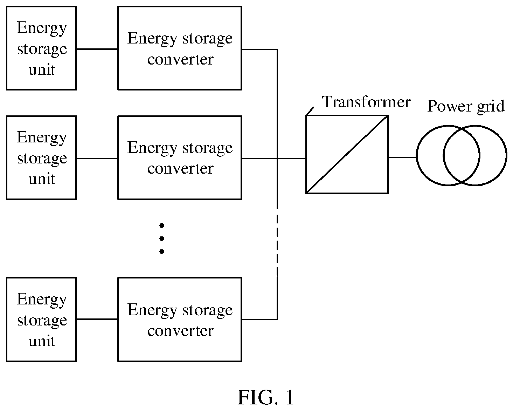

FIG. 1 is a diagram of an application scenario of an energy storage system according to this application. The energy storage system provided in this application may include a plurality of energy storage units, a plurality of energy storage converters, and a transformer. The energy storage converters include direct current ends and alternating current ends, the energy storage units are connected to the direct current ends of the energy storage converters, the alternating current ends of the plurality of energy storage converters are connected in parallel and then are connected to a power grid by using the transformer. Herein, the foregoing energy storage units may be connected to the direct current ends of the energy storage converters in a one-to-one correspondence. Alternatively, all the plurality of energy storage units may be connected to one output bus, and are connected to the direct current ends of the plurality of energy storage converters by using the output bus. That the energy storage units are connected to the direct current ends of the energy storage converters in a one-to-one correspondence is used as an example. As shown in FIG. 1, each energy storage unit in FIG. 1 is correspondingly connected to a direct current end of one energy storage converter, the energy storage unit may provide a direct current for the correspondingly connected energy storage converter, and the energy storage converter may convert the direct current from the energy storage unit into an alternating current and output the alternating current to the transformer. The transformer performs voltage transformation on the alternating current output by the energy storage converter, and outputs a transformed alternating current to the power grid. In addition, the foregoing energy storage converter may convert an alternating current from the power grid into a direct current and output the direct current to the energy storage unit to charge the energy storage unit.

In the energy storage system shown in FIG. 1, in a working process of the energy storage system, a ground impedance of the energy storage system may be abnormal due to a cause such as battery spill, improper construction, or friction between a cable and a support that occurs on the energy storage system. As a result, a short-circuit-to-ground fault occurs on an energy storage unit, a cable of an energy storage unit, a cable of a photovoltaic string, or the like in the system. If the short-circuit-to-ground fault in the system cannot be identified and intercepted in a timely manner, normal working of the energy storage system is greatly affected, and even a fire accident occurs. Therefore, it is very important to monitor a short-circuit fault of the ground impedance of the energy storage system to ensure safety of the energy storage system. In a current energy storage system, a dedicated detection device is usually installed to specially detect a ground impedance of the system.

For example, a ground impedance of each direct current side line in the energy storage system may be detected by using a ground insulation detection circuit, or a ground insulation detection apparatus may be installed to detect the ground impedance of the entire energy storage system. However, the ground insulation detection circuit can perform self-check only before an inverter or a converter in the energy storage system is powered on. When the energy storage system normally runs, ground impedance detection is interfered by a current in the energy storage system. The ground insulation detection apparatus may perform real-time detection when the energy storage system normally runs. However, ground impedance detection precision of the ground insulation detection apparatus is poor. When there are a large quantity of inverters or converters, the ground insulation detection apparatus cannot locate a specific short-circuit-to-ground fault. In addition, a protection threshold for the ground insulation detection apparatus to trigger short-circuit-to-ground fault determining is a fixed value, and adaptability to energy storage systems of different scales is poor.

In the energy storage system provided in this application, the energy storage system includes the plurality of energy storage converters, the plurality of energy storage units, one first insulation impedance detection apparatus, a plurality of second insulation impedance detection apparatuses, and a controller. The energy storage units are connected to the direct current ends of the energy storage converters, and the energy storage units are further connected to the second insulation impedance detection apparatuses in a one-to-one correspondence. The alternating current ends of the plurality of energy storage converters are connected in parallel and then are configured to connect to the power grid, or connect to the power grid by using one transformer, and a parallel connection point of the alternating current ends of the plurality of energy storage converters is connected to the first insulation impedance detection apparatus. The foregoing first insulation impedance detection apparatus is configured to detect a first insulation impedance, where the first insulation impedance includes a ground impedance value of the entire energy storage system, that is, may include an insulation impedance between the ground and a combination of the plurality of energy storage converters and the plurality of energy storage units. For example, the foregoing insulation impedance between the ground and a combination of the plurality of energy storage converters and the plurality of energy storage units may include an insulation impedance between the plurality of energy storage converters and the ground, an insulation impedance between the plurality of energy storage units and the ground, insulation impedances of connection cables between the energy storage converters and the energy storage units, and insulation impedances of connection cables between the energy storage converters and the power grid. The foregoing second insulation impedance detection apparatuses are configured to detect second insulation impedances, where the second insulation impedances include insulation impedances between the energy storage units connected to the second insulation impedance apparatuses and the ground. Herein, when the energy storage units are connected to the direct current ends of the energy storage converters in a one-to-one correspondence, the foregoing second insulation impedances may further include insulation impedances of connection cables between the energy storage units and the correspondingly connected energy storage converters. The controller in the energy storage system is configured to: when the first insulation impedance detected by the foregoing first insulation impedance detection apparatus is abnormal, control the plurality of second insulation impedance detection apparatuses to detect a plurality of corresponding second insulation impedances; and if there is an abnormal second insulation impedance, the controller sends an alarm signal that includes a short-circuit-to-ground of a corresponding energy storage unit. Herein, the energy storage system uses the controller to combine detection data from the first insulation impedance detection apparatus and the second insulation impedance detection apparatuses. When the first insulation impedance between the ground and a combination of the plurality of energy storage converters and the plurality of energy storage units that is detected by the first insulation impedance detection apparatus is abnormal, the second insulation impedance detection apparatuses are controlled one by one to detect the second insulation impedances of the corresponding energy storage units, so that real-time detection may be performed when the energy storage system normally runs, a specific short-circuit-to-ground fault can be located, and precision of short-circuit-to-ground fault detection is high, thereby greatly facilitating troubleshooting and rectification of the short-circuit-to-ground fault in the energy storage system.

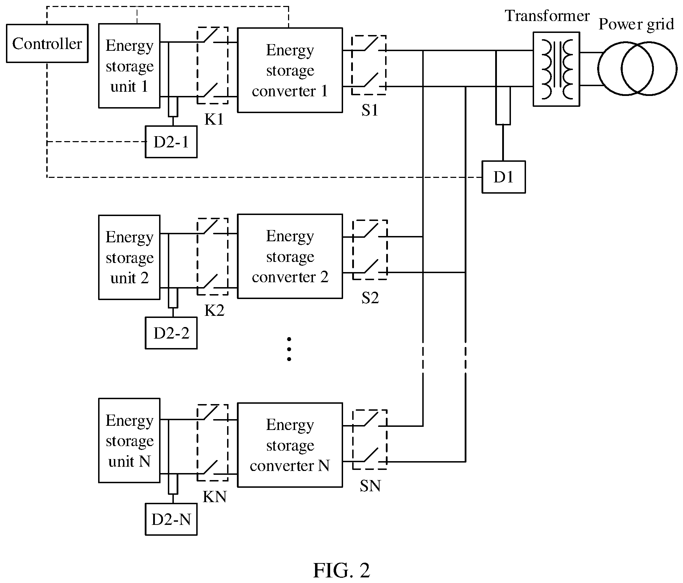

FIG. 2 is a diagram of a structure of an energy storage system according to this application. The energy storage system shown in FIG. 2 includes a plurality of energy storage converters, a plurality of energy storage units, one first insulation impedance detection apparatus, a plurality of second insulation impedance detection apparatuses, and a controller. Specifically, the energy storage system may include N energy storage units in total, including an energy storage unit 1, an energy storage unit 2, ..., and an energy storage unit N, and include N energy storage converters in total, including an energy storage converter 1, an energy storage converter 2, ..., and an energy storage converter N. The energy storage unit 1, the energy storage unit 2, ..., and the energy storage unit N are respectively connected to direct current ends of the energy storage converter 1, the energy storage converter 2, ..., and the energy storage converter N in a one-to-one correspondence, and alternating current ends of the energy storage converter 1, the energy storage converter 2, ..., and the energy storage converter N are connected in parallel and then connected to a power grid by using one transformer. A parallel connection point of the alternating current ends of the energy storage converter 1, the energy storage converter 2, ..., and the energy storage converter N is connected to the second insulation impedance detection apparatus D1. The energy storage system includes the plurality of second insulation impedance detection apparatuses, that is, includes N second insulation impedance detection apparatuses in total, including D2-1, D2-2, ..., and D2-N. D2-1, D2-2, ..., and D2-N are respectively connected to the energy storage unit 1, the energy storage unit 2, ..., and the energy storage unit N. The controller may be connected to the energy storage units, the energy storage converters, the first insulation impedance detection apparatus, and the second insulation impedance detection apparatuses by using communication cables. For example, the controller in FIG. 2 is connected to the energy storage unit 1, the energy storage converter 1, D1, and D2-1 by using communication cables, and a connection between the controller and another component is similar. The first insulation impedance detection apparatus in the energy storage system may be an IMD (Insulation Monitoring Device, insulation monitoring device), and the second insulation impedance detection apparatuses may be ISO (Insulation System Observation, insulation system observation) circuits. The foregoing first insulation impedance detection apparatus D1 is configured to detect a first insulation impedance, where the first insulation impedance includes a ground impedance value of the entire energy storage system, that is, may include an insulation impedance between the ground and a combination of the plurality of energy storage converters and the plurality of energy storage units. For example, the foregoing insulation impedance between the ground and a combination of the plurality of energy storage converters and the plurality of energy storage units may include an insulation impedance between the plurality of energy storage converters and the ground, an insulation impedance between the plurality of energy storage units and the ground, insulation impedances of connection cables between the energy storage converters and the energy storage units, and insulation impedances of connection cables between the energy storage converters and the power grid. The foregoing second insulation impedance detection apparatuses D2-1, D2-2, ..., and D2-N are configured to detect second insulation impedances, where the second insulation impedances include insulation impedances between the energy storage units and the ground and insulation impedances of connection cables between the energy storage units and the correspondingly connected energy storage converters. For example, D2-1 detects an insulation impedance between the energy storage unit 1 and the ground and an insulation impedance of a connection cable between the energy storage unit 1 and the energy storage converter 1, and D2-2 detects an insulation impedance between the energy storage unit 2 and the ground and an insulation impedance of a connection cable between the energy storage unit 2 and the energy storage converter 2. The controller in the energy storage system is configured to: when the first insulation impedance detected by the foregoing first insulation impedance detection apparatus D1 is abnormal, control the plurality of second insulation impedance detection apparatuses D2 to detect a plurality of corresponding second insulation impedances. For example, D2-1 is controlled to detect a corresponding second insulation impedance. If the second insulation impedance detected by D2-1 is normal, D2-2 is then controlled to detect a corresponding second insulation impedance. If the second insulation impedance detected by D2-2 is abnormal, the controller sends an alarm signal that includes a short-circuit-to-ground of the energy storage unit 2. Herein, the energy storage system uses the controller to combine detection data from the first insulation impedance detection apparatus and the second insulation impedance detection apparatuses. When the first insulation impedance detected by the first insulation impedance detection apparatus is abnormal, the second insulation impedance detection apparatuses are controlled one by one to detect the corresponding second insulation impedances, so that real-time detection may be performed when the energy storage system normally runs, a specific short-circuit-to-ground fault can be located, and precision of short-circuit-to-ground fault detection is high, thereby greatly facilitating troubleshooting and rectification of the short-circuit-to-ground fault in the energy storage system.

The controller in the energy storage system is configured to: when the first insulation impedance detected by the foregoing first insulation impedance detection apparatus is abnormal, determine that a short-circuit-to-ground fault occurs in the energy storage system, and control the plurality of second insulation impedance detection apparatuses to detect a plurality of corresponding second insulation impedances. Specifically, that the first insulation impedance is abnormal may be that the first insulation impedance is less than a first impedance alarm threshold. When the first insulation impedance is less than the first impedance alarm threshold, the controller controls the plurality of second insulation impedance detection apparatuses to detect the plurality of corresponding second insulation impedances. Further, after the controller controls all the second insulation impedance detection apparatuses to detect the plurality of corresponding second insulation impedances, if there is no abnormal second insulation impedance, it indicates that a short-circuit-to-ground fault is falsely reported, and the controller may reduce the foregoing first impedance alarm threshold. Then, the controller controls the first insulation impedance detection apparatus again to detect a first insulation impedance. If the first insulation impedance is less than a reduced first impedance alarm threshold, the controller controls the plurality of second insulation impedance detection apparatuses to detect a plurality of corresponding second insulation impedances. If there is no abnormal second insulation impedance, the controller continues to reduce the foregoing first impedance alarm threshold. Herein, the first impedance alarm threshold for the first insulation impedance detection apparatus to trigger short-circuit-to-ground fault determining is adjusted, so that when a short-circuit-to-ground fault is falsely reported, the first impedance alarm threshold is further corrected to adapt to a current energy storage system. This improves precision of short-circuit-to-ground fault detection, and is highly adaptable to energy storage systems of different scales. In addition, when a second insulation impedance is less than a second impedance alarm threshold, the second insulation impedance is abnormal. With reference to detection data of the first insulation impedance and the second insulation impedances, when the detected first insulation impedance between the ground and a combination of the plurality of energy storage converters and the plurality of energy storage units is abnormal, the plurality of second insulation impedance detection apparatuses are controlled one by one to obtain the plurality of second insulation impedances, and a specific short-circuit-to-ground fault is located based on whether a second insulation impedance is less than the second impedance alarm threshold.

That the first insulation impedance is abnormal may alternatively be that a difference between first insulation impedances detected by the first insulation impedance detection apparatus at two moments is greater than a specified threshold. Specifically, the controller in the energy storage system may obtain, at a plurality of moments, a plurality of first insulation impedances detected by the first insulation impedance detection apparatus. That the first insulation impedance is abnormal may be that a difference between first insulation impedances detected by the first insulation impedance detection apparatus at two adjacent moments is greater than a specified threshold, or that the first insulation impedance is abnormal may be that a difference between a real-time detection value and an initial detection value of the first insulation impedance detection apparatus is greater than a specified threshold. For example, the specified threshold is 10k, and first insulation impedances obtained by the controller at a moment T1, a moment T2, and a moment T3 are respectively 20k, 18k, and 5k (unit: ohm). A difference between first insulation impedances corresponding to adjacent moments T2 and T3 is 13k, and the difference is greater than the specified threshold. In this case, the controller determines that a short-circuit-to-ground fault occurs in the energy storage system, and continues to control the plurality of second insulation impedance detection apparatuses to detect a plurality of corresponding second insulation impedances. Herein, the controller obtains, at a plurality of moments, a plurality of first insulation impedances detected by the first insulation impedance detection apparatus, and determines, based on a difference between first insulation impedances detected at two moments, whether a short-circuit-to-ground fault occurs in the current energy storage system. This may improve precision of short-circuit-to-ground fault detection, and is highly adaptable to energy storage systems of different scales.

That the first insulation impedance is abnormal may alternatively be that in first insulation impedances detected by the first insulation impedance detection apparatus at two moments, a ratio of a first insulation impedance detected at an earlier moment to a first insulation impedance detected at a later moment is greater than a specified threshold, or a ratio of a first insulation impedance detected at a later moment to a first insulation impedance detected at an earlier moment is less than a specified threshold. Specifically, the controller in the energy storage system may obtain, at a plurality of moments, a plurality of first insulation impedances detected by the first insulation impedance detection apparatus. That the first insulation impedance is abnormal may be that a ratio between first insulation impedances detected by the first insulation impedance detection apparatus at two adjacent moments is greater than or less than a specified threshold, or that the first insulation impedance is abnormal may be that a ratio of a real-time detection value to an initial detection value of the first insulation impedance detection apparatus is greater than or less than a specified threshold. For example, the specified threshold is 2, and first insulation impedances obtained by the controller at a moment T1, a moment T2, and a moment T3 are respectively 20k, 18k, and 6k (unit: ohm). A ratio of a first insulation impedance corresponding to the moment T2 to a first insulation impedance corresponding to the adjacent moment T3 is 3, and the ratio is greater than the specified threshold. In this case, the controller determines that a short-circuit-to-ground fault occurs in the energy storage system, and continues to control the plurality of second insulation impedance detection apparatuses to detect a plurality of corresponding second insulation impedances. Alternatively, the specified threshold is 0.5, a ratio of the first insulation impedance corresponding to the moment T3 to the first insulation impedance corresponding to the adjacent moment T2 is 0.33, and the ratio is less than the specified threshold. In this case, the controller determines that a short-circuit-to-ground fault occurs in the energy storage system, and continues to control the plurality of second insulation impedance detection apparatuses to detect a plurality of corresponding second insulation impedances. Herein, the controller obtains, at a plurality of moments, a plurality of first insulation impedances detected by the first insulation impedance detection apparatus, and determines, based on a ratio between first insulation impedances detected at two moments, whether a short-circuit-to-ground fault occurs in the current energy storage system. This may improve precision of short-circuit-to-ground fault detection, and is highly adaptable to energy storage systems of different scales.

The controller is configured to: when the first insulation impedance is abnormal, control, one by one, connections between the plurality of energy storage converters and the power grid to be disconnected, and control a second insulation impedance detection apparatus corresponding to the energy storage converter disconnected from the power grid to detect the second insulation impedance. Refer to FIG. 2 again. In the energy storage system shown in FIG. 2, a connection line between an alternating current end of each energy storage converter and the transformer includes a switch. The alternating current ends of the energy storage converter 1, the energy storage converter 2, ..., and the energy storage converter N are connected to the transformer respectively by using a switch S1, a switch S2, ..., and a switch SN. In a working process of the energy storage system, the switch S1, the switch S2, ..., and the switch SN remain turned on. When the first insulation impedance is abnormal, the controller may control, one by one, the connections between the plurality of energy storage converters and the power grid to be disconnected, that is, control the switches to be turned off one by one. For example, in a sequence from the switch S1 to the switch SN, the controller may first control the switch S1 to be turned off to disconnect a connection between the energy storage converter 1 and the power grid, and control D2-1 to detect a second insulation impedance, that is, detect an insulation impedance between the energy storage unit 1 and the ground and an insulation impedance of a connection cable between the energy storage unit 1 and the energy storage converter 1. If the second insulation impedance detected by D2-1 is normal, the controller controls the switch S1 to be turned on, then controls the switch S2 to be turned off to disconnect a connection between the energy storage converter 2 and the power grid, and controls D2-2 to detect a second insulation impedance. A subsequent control process is similar, until a second insulation impedance corresponding to any second insulation impedance detection apparatus is abnormal. Herein, when the first insulation impedance is abnormal, the controller controls, one by one, the connections between the plurality of energy storage converters and the power grid to be disconnected, and controls a second insulation impedance detection apparatus corresponding to an energy storage converter that is disconnected from the power grid, to perform impedance detection, so that a specific short-circuit-to-ground fault is located with reference to detection data from the first insulation impedance detection apparatus and the second insulation impedance detection apparatuses without affecting normal working of the energy storage system, and precision of short-circuit-to-ground fault detection is high, thereby greatly facilitating troubleshooting and rectification of the short-circuit-to-ground fault in the energy storage system.

The controller is configured to: when the first insulation impedance is abnormal, control the plurality of second insulation impedance detection apparatuses to detect a plurality of corresponding second insulation impedances; and if there is an abnormal second insulation impedance, the controller is further configured to disconnect an electrical connection between a corresponding energy storage unit and a corresponding energy storage converter, where the corresponding energy storage unit is connected to a second insulation impedance detection apparatus that detects the abnormality, and a direct current end of the corresponding energy storage converter is connected to the second insulation impedance detection apparatus that detects the abnormality. Refer to FIG. 2 again. In the energy storage system shown in FIG. 2, a connection line between each energy storage unit and a direct current end of an energy storage converter includes a switch. The energy storage unit 1, the energy storage unit 2, ..., and the energy storage unit N are respectively connected to the direct current ends of the energy storage converter 1, the energy storage converter 2, ..., and the energy storage converter N by using a switch K1, a switch K2, ..., and a switch KN. In a working process of the energy storage system, the switch K1, the switch K2, ..., and the switch KN remain turned on. When there is an abnormal second insulation impedance, the controller may control a switch between a corresponding energy storage unit and a corresponding energy storage converter to be turned off. For example, if a second insulation impedance detected by D2-2 is abnormal, the controller may control the switch K2 between the energy storage unit 2 and the corresponding energy storage converter 2 to be turned off, to prevent the energy storage unit on which a short-circuit-to-ground fault occurs from affecting normal running of the energy storage system, thereby improving working reliability of the energy storage system.

The controller is configured to: in a startup phase of the energy storage system, or when the energy storage system runs in a non-charging and non-discharging phase, simultaneously control the connections between the plurality of energy storage converters and the power grid to be disconnected, and control the second insulation impedance detection apparatuses corresponding to the plurality of energy storage converters to detect second insulation impedances. Refer to FIG. 2 again. In the energy storage system shown in FIG. 2, when output power of all the plurality of power converters in the energy storage system is zero, the controller may directly control the connections between the plurality of energy storage converters and the power grid to be disconnected, that is, control the switch S1, the switch S2, ..., and the switch SN to be disconnected, and control D2-1, D2-2, ..., and D2-N to respectively detect corresponding second insulation impedances. When a second insulation impedance corresponding to any second insulation impedance detection apparatus is abnormal, the controller sends an alarm signal that includes a short-circuit-to-ground of an energy storage unit connected to the any second insulation impedance detection apparatus. Herein, in the startup phase of the energy storage system, or when the energy storage system runs in the non-charging and non-discharging phase, the controller simultaneously controls the connections between the plurality of energy storage converters and the power grid to be disconnected, and controls the second insulation impedance detection apparatuses corresponding to the plurality of energy storage converters to detect second insulation impedances. A specific short-circuit-to-ground fault is located, so that precision of short-circuit-to-ground fault detection is high.

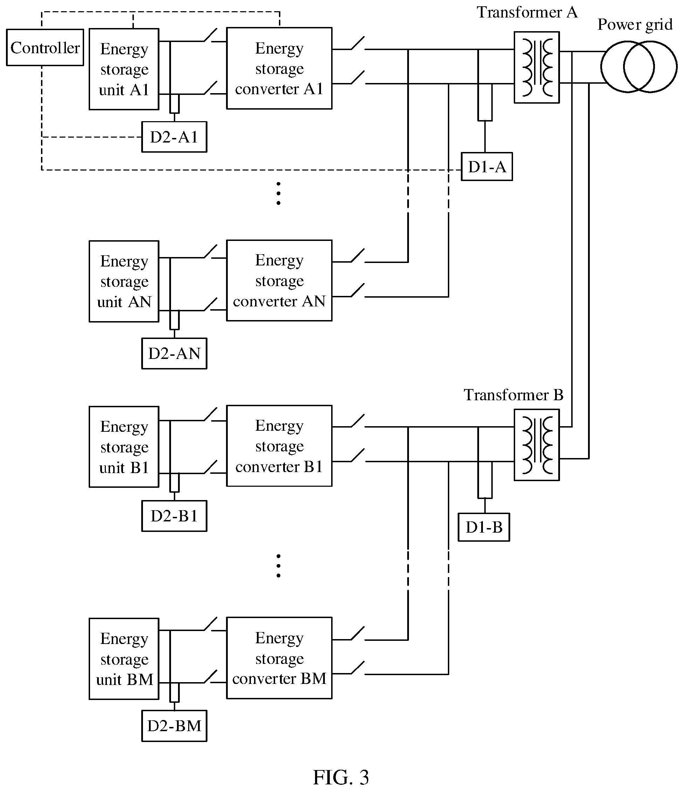

The energy storage system may include a plurality of power supply arrays and the controller. Each power supply array includes a plurality of energy storage converters, a plurality of energy storage units, one first insulation impedance detection apparatus, and a plurality of second insulation impedance detection apparatuses. In each power supply array, the energy storage units are connected to direct current ends of the energy storage converters, and the energy storage units are further connected to the second insulation impedance detection apparatuses in a one-to-one correspondence. Alternating current ends of the plurality of energy storage converters are connected in parallel and then are configured to connect to the power grid, or connect to the power grid by using one transformer, and a parallel connection point of the alternating current ends of the plurality of energy storage converters is connected to the first insulation impedance detection apparatus. That the energy storage system may include two power supply arrays is used as an example. FIG. 3 is another diagram of a structure of an energy storage system according to this application. The energy storage system shown in FIG. 3 includes two power supply arrays, where one power supply array includes N energy storage units in total, including an energy storage unit A1, an energy storage unit A2, ..., and an energy storage unit AN, and includes N energy storage converters in total, including an energy storage converter A1, an energy storage converter A2, ..., and an energy storage converter AN. The energy storage unit A1, the energy storage unit A2, ..., and the energy storage unit AN are respectively connected to direct current ends of the energy storage converter A1, the energy storage converter A2, ..., and the energy storage converter AN in a one-to-one correspondence, and alternating current ends of the energy storage converter A1, the energy storage converter A2, ..., and the energy storage converter AN are connected in parallel and then connected to a power grid by using one transformer A. The power supply array further includes a first insulation impedance detection apparatus D1-A and N second insulation impedance detection apparatuses in total, including D2-A1, D2-A2, ..., and D2-AN. D2-A1, D2-A2, ..., and D2-AN are respectively connected to the energy storage unit A1, the energy storage unit A2, ..., and the energy storage unit AN. The other power supply array includes M energy storage units in total, including an energy storage unit B1, an energy storage unit B2, ..., and an energy storage unit BM, and includes M energy storage converters in total, including an energy storage converter B1, an energy storage converter B2, ..., and an energy storage converter BM. The energy storage unit B1, the energy storage unit B2, ..., and the energy storage unit BM are respectively connected to direct current ends of the energy storage converter B1, the energy storage converter B2, ..., and the energy storage converter BM in a one-to-one correspondence, and alternating current ends of the energy storage converter B1, the energy storage converter B2, ..., and the energy storage converter BM are connected in parallel and then connected to the power grid by using one transformer B. The power supply array further includes a first insulation impedance detection apparatus D1-B and N second insulation impedance detection apparatuses in total, including D2-B1, D2-B2, ..., and D2-BN. D2-B1, D2-B2, ..., and D2-BN are respectively connected to the energy storage unit B1, the energy storage unit B2, ..., and the energy storage unit BM. The controller may be connected to the energy storage units, the energy storage converters, the first insulation impedance detection apparatus, and the second insulation impedance detection apparatuses by using communication cables. For example, the controller in FIG. 3 is connected to the energy storage unit A1, the energy storage converter A1, D1-A, and D2-A1 by using communication cables, and a connection between the controller and another component is similar. The controller may control insulation monitoring devices in a plurality of power supply arrays to detect an array-to-ground impedance value corresponding to each power supply array. When a difference between an array-to-ground impedance of at least one power supply array and an array-to-ground impedance of another power supply array is greater than a specified threshold, or a ratio is greater than a specified threshold, the controller determines that a short-circuit-to-ground fault occurs in the energy storage system, and controls second insulation impedance detection apparatuses in a corresponding power supply array to detect corresponding second insulation impedances. For example, the specified threshold is 10k. When an array-to-ground impedance value detected by D1-A is 20k, and an array-to-ground impedance value detected by D1-B is 8k, a difference between array-to-ground impedances is greater than the specified threshold. In this case, the controller determines that a short-circuit-to-ground fault occurs in the energy storage system, and continues to control the plurality of second insulation impedance detection apparatuses in the power supply array in which D1-B is located to detect a plurality of corresponding second insulation impedances. Alternatively, the specified threshold is 2. When an array-to-ground impedance value detected by D1-A is 20k, and an array-to-ground impedance value detected by D1-B is 8k, a ratio between array-to-ground impedances is greater than the specified threshold. In this case, the controller determines that a short-circuit-to-ground fault occurs in the energy storage system, and continues to control the plurality of second insulation impedance detection apparatuses in the power supply array in which D1-B is located to detect a plurality of corresponding second insulation impedances. For a process in which the controller controls the second insulation impedance detection apparatuses in the corresponding power supply array to detect the corresponding second insulation impedances, refer to the description of FIG. 3. Details are not described herein again. Herein, the controller simultaneously obtains a plurality of insulation impedances detected by ground insulation detection apparatuses in different power supply arrays, and determines, based on a difference between the obtained insulation impedances, whether a short-circuit-to-ground fault occurs in the current energy storage system. This may improve precision of short-circuit-to-ground fault detection, and is highly adaptable to energy storage systems of different scales.

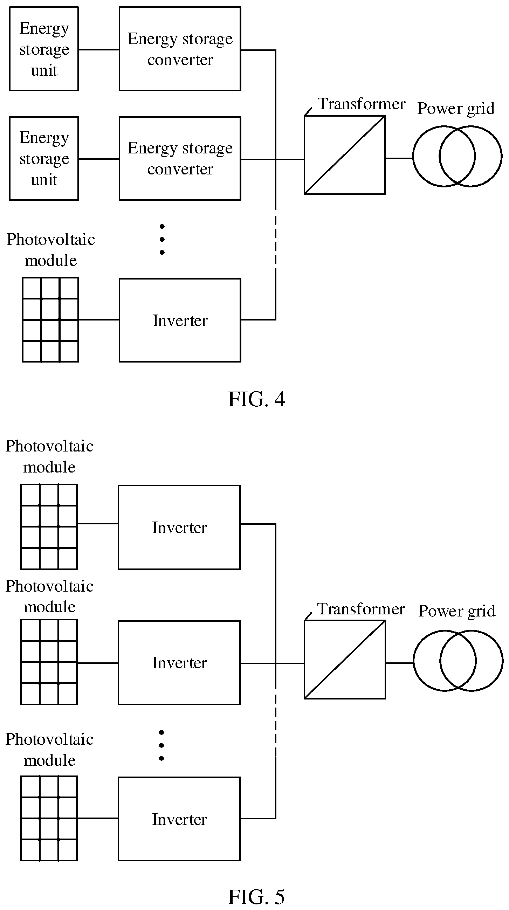

FIG. 4 is a diagram of an application scenario of a photovoltaic energy storage system according to this application. The photovoltaic energy storage system includes the plurality of energy storage units, the plurality of energy storage converters, and the transformer in the energy storage system shown in FIG. 1, and connection relationships between the energy storage units, the energy storage converters, and the transformer are similar to connection relationships in the energy storage system shown in FIG. 1. In addition, the photovoltaic energy storage system further includes photovoltaic modules and inverters. Output ends of the photovoltaic modules may be connected to input ends of the inverters, and output ends of the inverters are connected in parallel and then are connected to a power grid by using the transformer. The photovoltaic module may provide a direct current for the inverter, and the inverter may convert the direct current from the photovoltaic module into an alternating current and output the alternating current to the transformer. The transformer performs voltage transformation on the alternating current output by the inverter, and outputs a transformed alternating current to the power grid. A process in which the controller performs insulation impedance detection on the energy storage system and locates a specific short-circuit-to-ground fault in the energy storage system shown in FIG. 1 may also be applicable to the photovoltaic energy storage system. For a specific process, refer to the foregoing descriptions of FIG. 1 to FIG. 3. Details are not described herein again. FIG. 5 is a diagram of an application scenario of a photovoltaic system according to this application. The photovoltaic system includes photovoltaic modules and inverters. Output ends of the photovoltaic modules may be connected to input ends of the inverters, and output ends of the inverters are connected in parallel and then are connected to a power grid by using a transformer. The photovoltaic module may provide a direct current for the inverter, and the inverter may convert the direct current from the photovoltaic module into an alternating current and output the alternating current to the transformer. The transformer performs voltage transformation on the alternating current output by the inverter, and outputs a transformed alternating current to the power grid. A process in which the controller performs insulation impedance detection on the energy storage system and locates a specific short-circuit-to-ground fault in the energy storage system shown in FIG. 1 may also be applicable to the photovoltaic system. For a specific process, refer to the foregoing descriptions of FIG. 1 to FIG. 3. Details are not described herein again.

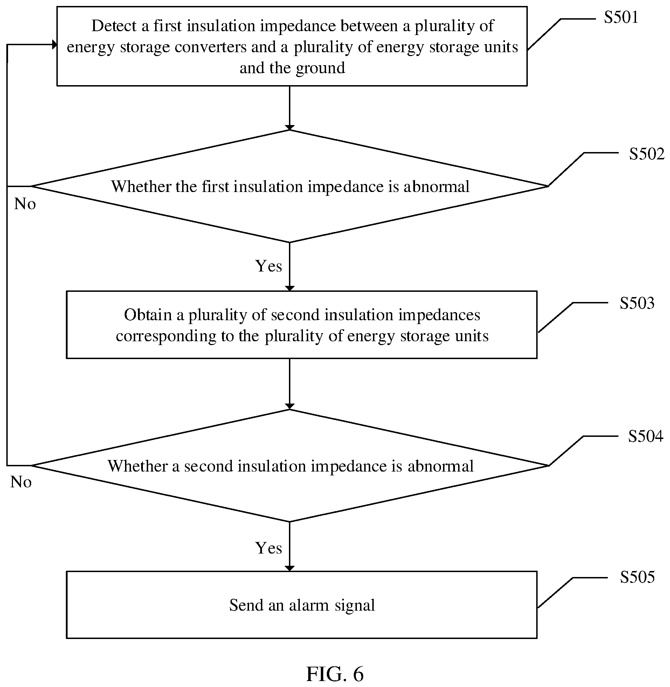

FIG. 6 is a schematic flowchart of an insulation impedance detection method for an energy storage system according to this application. The insulation impedance detection method for an energy storage system provided in this application is applicable to any one of the energy storage systems shown in FIG. 1 to FIG. 3. As shown in FIG. 6, the insulation impedance detection method for an energy storage system provided in this application includes the following steps:
S501: Detect a first insulation impedance between the ground and a combination of a plurality of energy storage converters and a plurality of energy storage units.
S502: Determine whether the first insulation impedance is abnormal; and if a determining result is yes, perform step S503; or if a determining result is no, perform step S501.

In some feasible implementations, the energy storage converters include direct current ends and alternating current ends, the energy storage units are connected to the direct current ends of the energy storage converters, and the alternating current ends of the plurality of energy storage converters are connected in parallel and then are configured to connect to a power grid. The first insulation impedance is detected, where the first insulation impedance includes a ground impedance value of the entire energy storage system, that is, may include an insulation impedance between the ground and a combination of the plurality of energy storage converters and the plurality of energy storage units. For example, the foregoing insulation impedance between the ground and a combination of the plurality of energy storage converters and the plurality of energy storage units may include an insulation impedance between the plurality of energy storage converters and the ground, an insulation impedance between the plurality of energy storage units and the ground, insulation impedances of connection cables between the energy storage converters and the energy storage units, and insulation impedances of connection cables between the energy storage converters and the power grid.

S503: Obtain a plurality of second insulation impedances corresponding to the plurality of energy storage units.

S504: Determine whether a second insulation impedance is abnormal; and if a determining result is yes, perform step S505; or if a determining result is no, perform step S501.

S505: Send an alarm signal.

In some feasible implementations, when the detected first insulation impedance is abnormal, the second insulation impedances corresponding to the plurality of energy storage units are obtained, and if there is an abnormal second insulation impedance, an alarm signal that includes a short-circuit-to-ground of a corresponding energy storage unit is sent. Herein, the second insulation impedances include insulation impedances between the energy storage units and the ground. With reference to detection data of the first insulation impedance and the second insulation impedances, when the detected first insulation impedance is abnormal, the second insulation impedances corresponding to the energy storage units are obtained one by one, so that real-time detection may be performed when the energy storage system normally runs, a specific short-circuit-to-ground fault can be located, and precision of short-circuit-to-ground fault detection is high, thereby greatly facilitating troubleshooting and rectification of the short-circuit-to-ground fault in the energy storage system.

That the first insulation impedance is abnormal may be that the first insulation impedance is less than a first impedance alarm threshold. When the first insulation impedance is less than the first impedance alarm threshold, the second insulation impedances corresponding to the plurality of energy storage units are obtained. Further, after the second insulation impedances corresponding to the plurality of energy storage units are obtained, if there is no abnormal second insulation impedance, it indicates that a short-circuit-to-ground fault is falsely reported, and the foregoing first impedance alarm threshold may be reduced. Then, a first insulation impedance is detected again. If the first insulation impedance is less than a reduced first impedance alarm threshold, second insulation impedances corresponding to the plurality of energy storage units are obtained. If there is no abnormal second insulation impedance, the foregoing first impedance alarm threshold continues to be reduced. Herein, the first impedance alarm threshold for triggering short-circuit-to-ground fault determining is adjusted, so that when a short-circuit-to-ground fault is falsely reported, the first impedance alarm threshold is further corrected to adapt to a current energy storage system. This improves precision of short-circuit-to-ground fault detection, and is highly adaptable to energy storage systems of different scales. In addition, when a second insulation impedance is less than a second impedance alarm threshold, the second insulation impedance is abnormal. With reference to detection data of the first insulation impedance and the second insulation impedances, when the detected first insulation impedance is abnormal, the second insulation impedances corresponding to the energy storage units are obtained one by one, and a specific short-circuit-to-ground fault is located based on whether a second insulation impedance is less than the second impedance alarm threshold.

In some feasible implementations, that the first insulation impedance is abnormal may alternatively be that a difference between first insulation impedances detected at two moments is greater than a specified threshold. Specifically, a plurality of first insulation impedances may be obtained at a plurality of moments. That the first insulation impedance is abnormal may be that a difference between first insulation impedances detected at two adjacent moments is greater than a specified threshold, or that the first insulation impedance is abnormal may be that a difference between a real-time detection value and an initial detection value is greater than a specified threshold. For example, the specified threshold is 10k, and first insulation impedances obtained at a moment T1, a moment T2, and a moment T3 are respectively 20k, 18k, and 5k (unit: ohm). A difference between first insulation impedances corresponding to adjacent moments T2 and T3 is 13k, and the difference is greater than the specified threshold. In this case, it is determined that a short-circuit-to-ground fault occurs in the energy storage system, and second insulation impedances corresponding to the plurality of energy storage units continue to be obtained. Herein, a plurality of first insulation impedances are obtained at a plurality of moments, and it is determined, based on a difference between first insulation impedances detected at two moments, whether a short-circuit-to-ground fault occurs in the current energy storage system. This may improve precision of short-circuit-to-ground fault detection, and is highly adaptable to energy storage systems of different scales.

In some feasible implementations, that the first insulation impedance is abnormal may alternatively be that in first insulation impedances detected at two moments, a ratio of a first insulation impedance detected at an earlier moment to a first insulation impedance detected at a later moment is greater than a specified threshold, or a ratio of a first insulation impedance detected at a later moment to a first insulation impedance detected at an earlier moment is less than a specified threshold. Specifically, a plurality of first insulation impedances may be obtained at a plurality of moments. That the first insulation impedance is abnormal may be that a ratio between first insulation impedances detected at two adjacent moments is greater than or less than a specified threshold, or that the first insulation impedance is abnormal may be that a ratio of a real-time detection value to an initial detection value is greater than or less than a specified threshold. For example, the specified threshold is 2, and first insulation impedances obtained at a moment T1, a moment T2, and a moment T3 are respectively 20k, 18k, and 6k (unit: ohm). A ratio of a first insulation impedance corresponding to the moment T2 to a first insulation impedance corresponding to the adjacent moment T3 is 3, and the ratio is greater than the specified threshold. In this case, it is determined that a short-circuit-to-ground fault occurs in the energy storage system, and second insulation impedances corresponding to the plurality of energy storage units continue to be obtained. Alternatively, the specified threshold is 0.5, a ratio of the first insulation impedance corresponding to the moment T3 to the first insulation impedance corresponding to the adjacent moment T2 is 0.33, and the ratio is less than the specified threshold. In this case, the controller determines that a short-circuit-to-ground fault occurs in the energy storage system, and continues to control the plurality of second insulation impedance detection apparatuses to detect a plurality of corresponding second insulation impedances. Herein, a plurality of first insulation impedances are obtained at a plurality of moments, and it is determined, based on a ratio between first insulation impedances detected at two moments, whether a short-circuit-to-ground fault occurs in the current energy storage system. This may improve precision of short-circuit-to-ground fault detection, and is highly adaptable to energy storage systems of different scales.

In some feasible implementations, when the first insulation impedance is abnormal, connections between the plurality of energy storage converters and the power grid are controlled to be disconnected one by one, and a second insulation impedance corresponding to an energy storage unit corresponding to an energy storage converter that is disconnected from the power grid is obtained. Herein, when the first insulation impedance is abnormal, the connections between the plurality of energy storage converters and the power grid are controlled to be disconnected one by one, and a second insulation impedance corresponding to an energy storage unit corresponding to an energy storage converter that is disconnected from the power grid is obtained, so that a specific short-circuit-to-ground fault is located with reference to detection data of the first insulation impedance and the second insulation impedances without affecting normal working of the energy storage system, and precision of short-circuit-to-ground fault detection is high, thereby greatly facilitating troubleshooting and rectification of the short-circuit-to-ground fault in the energy storage system.

In some feasible implementations, if there is an abnormal second insulation impedance, an electrical connection between an energy storage unit corresponding to the abnormal second insulation impedance and an energy storage converter is disconnected, to prevent the energy storage unit on which a short-circuit-to-ground fault occurs from affecting normal running of the energy storage system, thereby improving working reliability of the energy storage system.

## Claims

1. An energy storage system, wherein the energy storage system comprises a plurality of energy storage converters, a plurality of energy storage units, one first insulation impedance detection apparatus, a plurality of second insulation impedance detection apparatuses, and one controller, wherein
the energy storage converters comprise direct current ends and alternating current ends, the energy storage units are connected to the direct current ends of the energy storage converters, the energy storage units are further connected to the second insulation impedance detection apparatuses in a one-to-one correspondence, the alternating current ends of the plurality of energy storage converters are connected in parallel and then are configured to connect to a power grid, and a parallel connection point of the alternating current ends of the plurality of energy storage converters is connected to the first insulation impedance detection apparatus;
the first insulation impedance detection apparatus is configured to detect a first insulation impedance, wherein the first insulation impedance comprises an insulation impedance between the ground and a combination of the plurality of energy storage converters and the plurality of energy storage units;
one second insulation impedance detection apparatus is configured to detect a second insulation impedance, wherein the second insulation impedance comprises an insulation impedance between an energy storage unit connected to the one second insulation impedance detection apparatus and the ground; and
the controller is configured to: when the first insulation impedance is abnormal, control the plurality of second insulation impedance detection apparatuses to detect a plurality of corresponding second insulation impedances; and if there is an abnormal second insulation impedance, the controller sends an alarm signal.

2. The energy storage system according to claim 1, wherein that the first insulation impedance is abnormal comprises that the first insulation impedance is less than a first impedance alarm threshold, and if there is no abnormal second insulation impedance, the controller is further configured to reduce the first impedance alarm threshold.

3. The energy storage system according to claim 1, wherein that the first insulation impedance is abnormal comprises that a difference between the first insulation impedances detected by the first insulation impedance detection apparatus at two moments is greater than a specified threshold.

4. The energy storage system according to claim 1, wherein that the first insulation impedance is abnormal comprises that in the first insulation impedances detected by the first insulation impedance detection apparatus at two moments, a ratio of the first insulation impedance detected at an earlier moment to the first insulation impedance detected at a later moment is greater than a specified threshold.

5. The energy storage system according to claim 1, wherein that the first insulation impedance is abnormal comprises that in the first insulation impedances detected by the first insulation impedance detection apparatus at two moments, a ratio of the first insulation impedance detected at a later moment to the first insulation impedance detected at an earlier moment is less than a specified threshold.

6. The energy storage system according to any one of claims 1 to 5, wherein the controller is configured to: when the first insulation impedance is abnormal, control, one by one, connections between the plurality of energy storage converters and the power grid to be disconnected, and control a second insulation impedance detection apparatus corresponding to the energy storage converter disconnected from the power grid to detect the second insulation impedance.

7. The energy storage system according to claim 6, wherein the controller is configured to: when the first insulation impedance is abnormal, control the plurality of second insulation impedance detection apparatuses to detect a plurality of corresponding second insulation impedances; and if there is an abnormal second insulation impedance, the controller is further configured to disconnect an electrical connection between a corresponding energy storage unit and a corresponding energy storage converter, wherein the corresponding energy storage unit is connected to a second insulation impedance detection apparatus that detects the abnormal second insulation impedance, and a direct current end of the corresponding energy storage converter is connected to the second insulation impedance detection apparatus that detects the abnormal second insulation impedance.

8. The energy storage system according to claim 7, wherein the energy storage units are connected to the direct current ends of the energy storage converters in a one-to-one correspondence, and the second insulation impedances further comprise insulation impedances of connection cables between the energy storage units and the correspondingly connected energy storage converters.

9. The energy storage system according to claim 8, wherein that the second insulation impedance is abnormal comprises that the second insulation impedance is less than a second impedance alarm threshold.

10. An insulation impedance detection method for an energy storage system, wherein the method comprises:
detecting a first insulation impedance, wherein the first insulation impedance comprises an insulation impedance between the ground and a combination of a plurality of energy storage converters and a plurality of energy storage units, the energy storage converters comprise direct current ends and alternating current ends, the energy storage units are connected to the direct current ends of the energy storage converters, and the alternating current ends of the plurality of energy storage converters are connected in parallel and then are configured to connect to a power grid, and
when the first insulation impedance is abnormal, obtaining a plurality of second insulation impedances, and if there is an abnormal second insulation impedance, sending an alarm signal, wherein the second insulation impedances comprise insulation impedances between the energy storage units and the ground.

## Patentansprüche

1. Energiespeichersystem, wobei das Energiespeichersystem eine Vielzahl von Energiespeicherumwandlern, eine Vielzahl von Energiespeichereinheiten, eine erste Isolationsimpedanzdetektionsvorrichtung, eine Vielzahl von zweiten Isolationsimpedanzdetektionsvorrichtungen und eine Steuerung umfasst, wobei
die Energiespeicherumwandler Gleichstromenden und Wechselstromenden umfassen, die Energiespeichereinheiten mit den Gleichstromenden der Energiespeicherumwandler verbunden sind, die Energiespeichereinheiten ferner in einer Eins-zu-Eins-Korrespondenz mit den zweiten Isolationsimpedanzdetektionsvorrichtungen verbunden sind, die Wechselstromenden der Vielzahl von Energiespeicherumwandlern parallel verbunden sind und dann ausgelegt sind, um sich mit einem Stromnetz zu verbinden, und ein Parallelverbindungspunkt der Wechselstromenden der Vielzahl von Energiespeicherumwandlern mit der ersten Isolationsimpedanzdetektionsvorrichtung verbunden ist;
die erste Isolationsimpedanzdetektionsvorrichtung ausgelegt ist, um eine erste Isolationsimpedanz zu detektieren, wobei die erste Isolationsimpedanz eine Isolationsimpedanz zwischen der Erde und einer Kombination der Vielzahl von Energiespeicherumwandlern und der Vielzahl von Energiespeichereinheiten umfasst;
eine zweite Isolationsimpedanzdetektionsvorrichtung ausgelegt ist, um eine zweite Isolationsimpedanz zu detektieren, wobei die zweite Isolationsimpedanz eine Isolationsimpedanz zwischen einer mit der einen zweiten Isolationsimpedanzdetektionsvorrichtung verbundenen Energiespeichereinheit und der Erde umfasst; und
die Steuerung ausgelegt ist, um: die Vielzahl von zweiten Isolationsimpedanzdetektionsvorrichtungen so zu steuern, dass sie eine Vielzahl von entsprechenden zweiten Isolationsimpedanzen detektieren, wenn die erste Isolationsimpedanz anormal ist; und die Steuerung ein Alarmsignal sendet, wenn eine anormale zweite Isolationsimpedanz vorliegt.

2. Energiespeichersystem nach Anspruch 1, wobei der Umstand, dass die erste Isolationsimpedanz anormal ist, umfasst, dass die erste Isolationsimpedanz weniger als ein erster Impedanzalarmschwellenwert ist, und die Steuerung ferner ausgelegt ist, um den ersten Impedanzalarmschwellenwert zu reduzieren, wenn keine anormale zweite Isolationsimpedanz vorliegt.

3. Energiespeichersystem nach Anspruch 1, wobei der Umstand, dass die erste Isolationsimpedanz anormal ist, umfasst, dass eine Differenz zwischen den ersten Isolationsimpedanzen, die von der ersten Isolationsimpedanzdetektionsvorrichtung zu zwei Zeitpunkten detektiert werden, größer als ein definierter Schwellenwert ist.

4. Energiespeichersystem nach Anspruch 1, wobei der Umstand, dass die erste Isolationsimpedanz anormal ist, umfasst, dass innerhalb der ersten Isolationsimpedanzen, die von der ersten Isolationsimpedanzdetektionsvorrichtung zu zwei Zeitpunkten detektiert werden, ein Verhältnis der ersten zu einem früheren Zeitpunkt detektierten Isolationsimpedanz zu der ersten zu einem späteren Zeitpunkt detektierten Isolationsimpedanz größer als ein definierter Schwellenwert ist.

5. Energiespeichersystem nach Anspruch 1, wobei der Umstand, dass die erste Isolationsimpedanz anormal ist, umfasst, dass innerhalb der ersten Isolationsimpedanzen, die von der ersten Isolationsimpedanzdetektionsvorrichtung zu zwei Zeitpunkten detektiert werden, ein Verhältnis der ersten zu einem späteren Zeitpunkt detektierten Isolationsimpedanz zu der ersten zu einem früheren Zeitpunkt detektierten Isolationsimpedanz weniger als ein definierter Schwellenwert ist.

6. Energiespeichersystem nach einem der Ansprüche 1 bis 5, wobei die Steuerung ausgelegt ist, um: Verbindungen zwischen der Vielzahl von Energiespeicherumwandlern und dem Stromnetz nacheinander so zu steuern, dass sie getrennt werden, wenn die erste Isolationsimpedanz anormal ist, und eine dem von dem Stromnetz getrennten Energiespeicherumwandler entsprechende zweite Isolationsimpedanzdetektionsvorrichtung so zu steuern, dass sie die zweite Isolationsimpedanz detektiert.

7. Energiespeichersystem nach Anspruch 6, wobei die Steuerung ausgelegt ist, um: die Vielzahl von zweiten Isolationsimpedanzdetektionsvorrichtungen so zu steuern, dass sie eine Vielzahl von entsprechenden zweiten Isolationsimpedanzen detektieren, wenn die erste Isolationsimpedanz anormal ist; und die Steuerung ferner ausgelegt ist, um eine elektrische Verbindung zwischen einer entsprechenden Energiespeichereinheit und einem entsprechenden Energiespeicherumwandler zu trennen, wenn eine anormale zweite Isolationsimpedanz vorliegt, wobei die entsprechende Energiespeichereinheit mit einer zweiten Isolationsimpedanzdetektionsvorrichtung verbunden ist, die die anormale zweite Isolationsimpedanz detektiert, und ein Gleichstromende des entsprechenden Energiespeicherumwandlers mit der zweiten Isolationsimpedanzdetektionsvorrichtung verbunden ist, die die anormale zweite Isolationsimpedanz detektiert.

8. Energiespeichersystem nach Anspruch 7, wobei die Energiespeichereinheiten in einer Eins-zu-Eins-Korrespondenz mit den Gleichstromenden der Energiespeicherumwandler verbunden sind und die zweiten Isolationsimpedanzen ferner Isolationsimpedanzen von Verbindungskabeln zwischen den Energiespeichereinheiten und den entsprechend verbundenen Energiespeicherumwandlern umfassen.

9. Energiespeichersystem nach Anspruch 8, wobei der Umstand, dass die zweite Isolationsimpedanz anormal ist, umfasst, dass die zweite Isolationsimpedanz weniger als ein zweiter Impedanzalarmschwellenwert ist.

10. Isolationsimpedanzdetektionsverfahren für ein Energiespeichersystem, wobei das Verfahren umfasst:
Detektieren einer ersten Isolationsimpedanz, wobei die erste Isolationsimpedanz eine Isolationsimpedanz zwischen der Erde und einer Kombination einer Vielzahl von Energiespeicherumwandlern und einer Vielzahl von Energiespeichereinheiten umfasst, die Energiespeicherumwandler Gleichstromenden und Wechselstromenden umfassen, die Energiespeichereinheiten mit den Gleichstromenden der Energiespeicherumwandler verbunden sind und die Wechselstromenden der Vielzahl von Energiespeicherumwandlern parallel verbunden sind und dann ausgelegt sind, um sich mit einem Stromnetz zu verbinden; und
Erhalten einer Vielzahl von zweiten Isolationsimpedanzen, wenn die erste Isolationsimpedanz anormal ist, und Senden eines Alarmsignals, wenn eine anormale zweite Isolationsimpedanz vorliegt, wobei die zweiten Isolationsimpedanzen Isolationsimpedanzen zwischen den Energiespeichereinheiten und der Erde umfassen.

## Revendications

1. Système de stockage d'énergie, dans lequel le système de stockage d'énergie comprend une pluralité de convertisseurs de stockage d'énergie, une pluralité d'unités de stockage d'énergie, un premier appareil de détection d'impédance d'isolation, une pluralité de seconds appareils de détection d'impédance d'isolation, et un dispositif de commande, dans lequel
les convertisseurs de stockage d'énergie comprennent des extrémités à courant continu et des extrémités à courant alternatif, les unités de stockage d'énergie sont connectées aux extrémités à courant continu des convertisseurs de stockage d'énergie, les unités de stockage d'énergie sont en outre connectées aux seconds appareils de détection d'impédance d'isolation en correspondance biunivoque, les extrémités à courant alternatif de la pluralité de convertisseurs de stockage d'énergie sont connectées en parallèle puis sont configurées pour se connecter à un réseau électrique, et un point de connexion parallèle des extrémités à courant alternatif de la pluralité de convertisseurs de stockage d'énergie est connecté au premier appareil de détection d'impédance d'isolation ;
le premier appareil de détection d'impédance d'isolation est configuré pour détecter une première impédance d'isolation, dans lequel la première impédance d'isolation comprend une impédance d'isolation entre la terre et une combinaison de la pluralité de convertisseurs de stockage d'énergie et de la pluralité d'unités de stockage d'énergie ;
un second appareil de détection d'impédance d'isolation est configuré pour détecter une seconde impédance d'isolation, dans lequel la seconde impédance d'isolation comprend une impédance d'isolation entre une unité de stockage d'énergie connectée au second appareil de détection d'impédance d'isolation et à la terre ; et
le dispositif de commande est configuré pour : lorsque la première impédance d'isolation est anormale, commander la pluralité de seconds appareils de détection d'impédance d'isolation pour détecter une pluralité de secondes impédances d'isolation correspondantes ; et s'il y a une seconde impédance d'isolation anormale, le dispositif de commande envoie un signal d'alarme.

2. Système de stockage d'énergie selon la revendication 1, dans lequel le fait que la première impédance d'isolation est anormale comprend le fait que la première impédance d'isolation est inférieure à un premier seuil d'alarme d'impédance, et s'il n'y a pas de seconde impédance d'isolation anormale, le dispositif de commande est en outre configuré pour réduire le premier seuil d'alarme d'impédance.

3. Système de stockage d'énergie selon la revendication 1, dans lequel le fait que la première impédance d'isolation est anormale comprend le fait qu'une différence entre les premières impédances d'isolation détectées par le premier appareil de détection d'impédance d'isolation à deux moments est supérieure à un seuil spécifié.

4. Système de stockage d'énergie selon la revendication 1, dans lequel le fait que la première impédance d'isolation est anormale comprend le fait que dans les premières impédances d'isolation détectées par le premier appareil de détection d'impédance d'isolation à deux moments, un rapport de la première impédance d'isolation détectée à un moment antérieur à la première impédance d'isolation détectée à un moment ultérieur est supérieur à un seuil spécifié.

5. Système de stockage d'énergie selon la revendication 1, dans lequel le fait que la première impédance d'isolation est anormale comprend le fait que dans les premières impédances d'isolation détectées par le premier appareil de détection d'impédance d'isolation à deux moments, un rapport de la première impédance d'isolation détectée à un moment ultérieur à la première impédance d'isolation détectée à un moment antérieur est inférieur à un seuil spécifié.

6. Système de stockage d'énergie selon l'une quelconque des revendications 1 à 5, dans lequel le dispositif de commande est configuré pour : lorsque la première impédance d'isolation est anormale, commander, une par une, les connexions entre la pluralité de convertisseurs de stockage d'énergie et le réseau électrique à se déconnecter, et commander un second appareil de détection d'impédance d'isolation correspondant au convertisseur de stockage d'énergie déconnecté du réseau électrique pour détecter la seconde impédance d'isolation.

7. Système de stockage d'énergie selon la revendication 6, dans lequel le dispositif de commande est configuré pour : lorsque la première impédance d'isolation est anormale, commander la pluralité de seconds appareils de détection d'impédance d'isolation pour détecter une pluralité de secondes impédances d'isolation correspondantes ; et s'il existe une seconde impédance d'isolation anormale, le dispositif de commande est en outre configuré pour déconnecter une connexion électrique entre une unité de stockage d'énergie correspondante et un convertisseur de stockage d'énergie correspondant, dans lequel l'unité de stockage d'énergie correspondante est connectée à un second appareil de détection d'impédance d'isolation qui détecte la seconde impédance d'isolation anormale, et une extrémité à courant continu du convertisseur de stockage d'énergie correspondant est connectée au second appareil de détection d'impédance d'isolation qui détecte la seconde impédance d'isolation anormale.

8. Système de stockage d'énergie selon la revendication 7, dans lequel les unités de stockage d'énergie sont connectées aux extrémités à courant continu des convertisseurs de stockage d'énergie en correspondance biunivoque, et les secondes impédances d'isolation comprennent en outre les impédances d'isolation de câbles de connexion entre les unités de stockage d'énergie et les convertisseurs de stockage d'énergie connectés en conséquence.

9. Système de stockage d'énergie selon la revendication 8, dans lequel le fait que la seconde impédance d'isolation est anormale comprend le fait que la seconde impédance d'isolation est inférieure à un second seuil d'alarme d'impédance.

10. Procédé de détection d'impédance d'isolation pour un système de stockage d'énergie, dans lequel le procédé comprend :
la détection d'une première impédance d'isolation, dans lequel la première impédance d'isolation comprend une impédance d'isolation entre la terre et une combinaison d'une pluralité de convertisseurs de stockage d'énergie et une pluralité d'unités de stockage d'énergie, les convertisseurs de stockage d'énergie comprennent des extrémités à courant continu et des extrémités à courant alternatif, les unités de stockage d'énergie sont connectées aux extrémités à courant continu des convertisseurs de stockage d'énergie, et les extrémités à courant alternatif de la pluralité des convertisseurs de stockage d'énergie sont connectées en parallèle puis sont configurées pour se connecter à un réseau électrique ; et
lorsque la première impédance d'isolation est anormale, l'obtention d'une pluralité de secondes impédances d'isolation, et s'il y a une seconde impédance d'isolation anormale, l'envoi d'un signal d'alarme, dans lequel les secondes impédances d'isolation comprennent les impédances d'isolation entre les unités de stockage d'énergie et la terre.
